# EUROPEAN PATENT APPLICATION

(11) **EP 2 267 468 A1**
(43) Date of publication of application: **29.12.2010**
(21) Application number: 10160587.1
(22) Date of filing: 21.04.2010
(51) Int. Cl.: G01R 31/12, G01R 31/00

(54) **Monitoring system and method for wiring systems**

(30) Priority: 24.06.2009 US 490912
(71) Applicant: General Electric Company, Schenectady, NY 12345 (US)
(72) Inventor: BULUMULLA, Selaka Bandara, Niskayuna, NY 12309 (US)
(74) Representative: Gray, Thomas

(57) **Abstract**

A system (10) for monitoring one or more components (20) of an aircraft wiring system component is provided. The system (10) comprises at least one sensor (11) configured to detect one or more partial discharges produced by a respective one of the components (20) of the aircraft wiring system and to generate at least one monitoring signal (100), at least one electrical-to-optical converter (14) configured to convert the monitoring signal (100) to an optical signal, at least one optical connector (12) configured to transmit the optical signal, and at least one optical-to-electrical converter (15) configured to convert the optical signal to an electrical signal. The system (10) further comprises a data acquisition system (13) configured to process the electrical signal. Further, a method for monitoring one or more components (20) of an aircraft wiring system component is also presented.

## Description

### BACKGROUND OF THE DISCLOSURE

The invention relates generally to systems and methods for monitoring insulated wiring systems. More particularly, this invention relates to systems and methods for monitoring aircraft wiring systems using partial discharge analysis.

Wiring is a critical system in aircraft, shipboard, industry and home applications. Aircraft wiring integrity and safety related issues are known to be serious. Also, electrical fires in industry account for a large portion of property loss, and electrical fires in the home account for a significant portion of the fires occurring in the home that threaten life and damage property.

Aircraft wiring insulation is much thinner than that found in building wiring in order to reduce weight. This thin insulation can deteriorate with age due to changes in chemical composition, vibration during flights, large temperature changes, and exposure to agents such as dust, salt, moisture, hydraulic oil and jet fuel. This wiring is also exposed to other mechanical stresses, and occasionally, unintentional damage during maintenance. The aforementioned effects can degrade the insulation, causing cracks and chafing. These insulation defects can cause arcing between wires or surrounding metals. Humidity together with salt and dust depositions can make the arc creation more probable.

Partial discharge sensors can be used to monitor the condition of the insulation in aircraft wiring systems. For current applications, shielded coaxial cables are employed to transmit detected signals from the partial discharge sensors. However, the use of shielded coaxial cables increases the weight of the aircraft wiring systems, which conflicts with the requirement of reducing weight in aircraft applications.

Therefore, there is a need for a new and improved system and method for monitoring aircraft wiring systems.

### BRIEF DESCRIPTION OF THE DISCLOSURE

A system for monitoring one or more components of an aircraft wiring system is provided in accordance with one embodiment of the invention. The system comprises at least one sensor configured to detect one or more partial discharges produced by a respective one of the components of the aircraft wiring system and to generate at least one monitoring signal, at least one electrical-to-optical converter configured to convert the monitoring signal to an optical signal, at least one optical connector configured to transmit the optical signal, and at least one optical-to-electrical converter configured to convert the optical signal to an electrical signal. The system further comprises a data acquisition system configured to process the electrical signal.

A method for monitoring one or more components of an aircraft wiring system is provided in accordance with another embodiment of the invention. The method comprises detecting one or more partial discharges produced by a respective one of the aircraft wiring system components to generate one or more monitoring signals, converting the one or more electrical monitoring signals to one or more optical monitoring signals, transmitting the one or more optical signals towards a data acquisition system, converting the one or more optical signals to one or more electrical signals for transmission into the data acquisition system, and processing the one or more electrical signals to determine a condition of the respective aircraft wiring system component.

These and other advantages and features will be more understood from the following detailed description of preferred embodiments of the invention that is provided in connection with the accompanying drawings.

### BRIEF DESCRIPTION OF THE DRAWINGS

There follows a detailed description of embodiments of the invention by way of example only with reference to the accompanying drawings, in which:
FIG. 1 is a schematic diagram of a monitoring system in accordance with one embodiment of the invention;
FIG. 2 is a schematic diagram of an exemplary arrangement of the monitoring system in accordance with one embodiment of the invention;
FIG. 3 is a schematic diagram of an external modulator of the monitoring system;
FIG. 4 is a schematic diagram of an exemplary power source of the monitoring system;
FIGS. 5(a)-5(b) are a perspective view and a top view of an exemplary package of some elements of the monitoring system; and
FIG. 6 is a schematic diagram of an exemplary arrangement of the monitoring system in accordance with another embodiment of the invention.

### DETAILED DESCRIPTION OF THE INVENTION

Preferred embodiments of the present disclosure will be described hereinbelow with reference to the accompanying drawings. In the following description, well-known functions or constructions are not described in detail to avoid obscuring the disclosure in unnecessary detail.

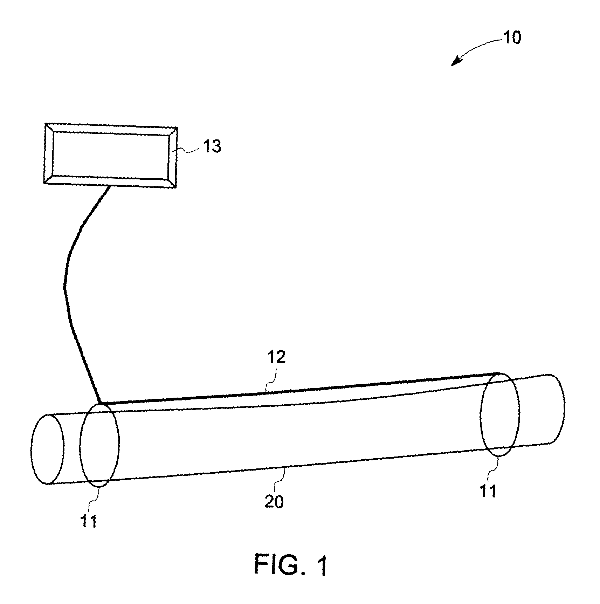

FIG. 1 is a schematic diagram of a monitoring system 10 in accordance with one embodiment of the invention. In embodiments of the invention, the monitoring system 10 is configured to monitor the insulation condition of one or more components 20 (shown in FIG. 1) of an aircraft wiring system (not shown) using partial discharge analysis. In some embodiments, the component 20 may comprise high voltage and high current power feeder circuits, subsystem power distribution circuits, and system and subsystem signal lines. In non-limiting examples, the component 20 may comprise twenty-eight voltage direct current (DC) power supply lines and communication lines for transmitting low voltage signals. Particularly, the components 20 may include wires, in some applications, which may be bundled together to form a harness.

For the example arrangement depicted in FIG. 1, the monitoring system 10 comprises two sensors 11, an optical connector 12, and a data acquisition system 13. The invention is not limited to any specific number of sensors, and the depicted arrangement is merely for the purpose of illustration. In addition, one or more sensors 11 may be used to monitor a given component 20. In some embodiments, each of the sensors 11 comprises an annular shape and is disposed around respective ones of the components 20 to monitor partial discharge(s) produced in the components 20 to generate at least one monitoring signal. As used herein, the phrase "partial discharges" may indicate electric discharges that do not completely bridge adjacent conductors. The magnitude of such discharges is usually small, and the amount of charge transferred is in a range of ten to a few hundred pico-Coulombs. In some applications, the sensor 11 may be of a voltage pulse detection type or of a current pulse detection type. In one non-limiting example, the sensor 11 may comprise a high frequency current transformer including, but not limited to a Rogowski coil.

The optical connector 12 optically transmits the monitoring signal, such as an alternating current monitoring signal, from the sensors 11 to the data acquisition system 13. As noted above, the depicted arrangement in FIG. 1 is merely illustrative. The monitoring system 10 may comprise one or more sensors encompassing the component 20 respectively, and one or more optical connectors to communicate with the respective sensors. In addition, the system 10 may be configured to monitor multiple components 20, in which case one or more sensors encompass respective ones of the components. In some embodiments, each of the optical connectors may comprise one or more optical fibers to transmit the monitoring signals. In alternative embodiments, the optical transmission may comprise free-space optical transmission.

The data acquisition system 13 is configured to process, for example, to receive and/or store the monitoring signals. In certain applications, the monitoring signals may be used to identify waveform signatures through an expert algorithm system (not shown) and to alert a central system (not shown) for monitoring the aircraft wiring system. In some embodiments, the data acquisition system 13 may comprise one or more processors to process the monitoring signals. It should be noted that the present invention is not limited to any particular processor for performing the processing tasks of the invention. The term "processor", as that term is used herein, is intended to denote any machine capable of performing the calculations, or computations, necessary to perform the tasks of the invention. The term "processor" is intended to denote any machine that is capable of accepting a structured input and/or of processing the input in accordance with prescribed rules to produce an output, as will be understood by those skilled in the art.

In non-limiting examples, the data acquisition system 13 may include a receiver and a memory (not shown) to receive and store the monitoring signals, respectively. In one non-limiting example, the receiver comprises a radio-frequency receiver, and the memory comprises a central-processing unit (CPU). Additionally, the data acquisition system 13 may further comprise a display (not shown), such as a liquid crystal display (LCD) to display the status of the component 20. Other descriptions of such example data acquisition systems may be found in U.S. Pat. No. 6,930,610, entitled "monitoring system and method for wiring systems," which is hereby incorporated by reference in its entirely herein.

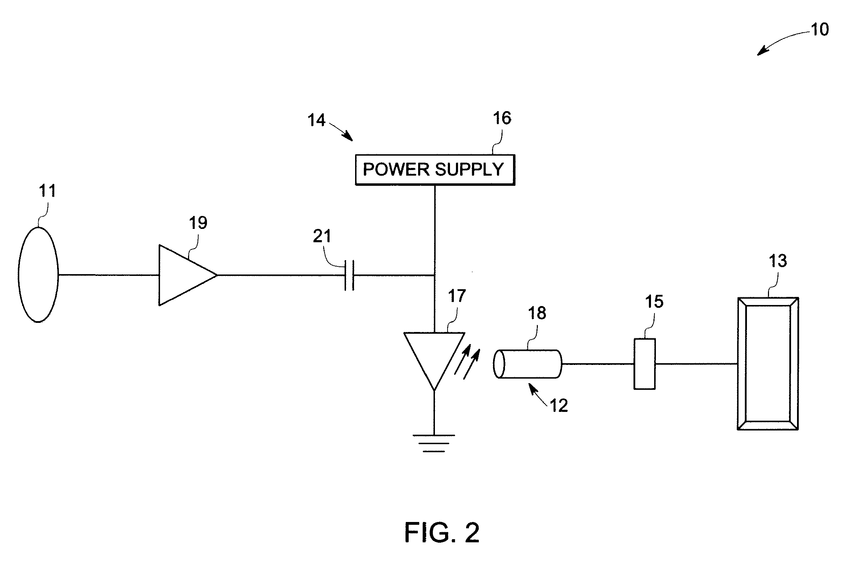

FIG. 2 is a schematic diagram of an exemplary arrangement of the monitoring system 10 in accordance with one embodiment of the invention. For ease of illustration, one sensor 11 is illustrated as an example, and the same numerals in FIGS. 1-4 may indicate similar elements.

For the exemplary arrangement depicted in FIG. 2, the monitoring system 10 comprises a sensor 11, an optical connector 12, and a data acquisition system 13. An electrical-to-optical converter 14 is disposed at an interface between the sensor 11 and the optical connector 12, and an optical-to-electrical converter 15 is disposed between the optical connector 12 and the data acquisition system 13. The optical connector 12 comprises an optical fiber 18. The electrical-to-optical converter 14 comprises a signal modulator 17 and a power supply 16 connected to one end of the signal modulator 17 with the other end connected to ground.

In embodiments of the invention, the power supply 16 is configured to power the signal modulator 17. In one non-limiting example, the power supply 16 may generate direct current (DC) power. The signal modulator 17 is configured to convert the alternating current (AC) monitoring signal from the sensor 11 to an optical signal. In the illustrated embodiment, the signal modulator 17 comprises a direct modulator, such as a vertical-cavity surface-emitting laser (VCSEL). Alternatively, the signal modulator 17 may comprise an external modulator including, but not limited to a Mach-Zehnder modulator or an electroabsorption modulator.

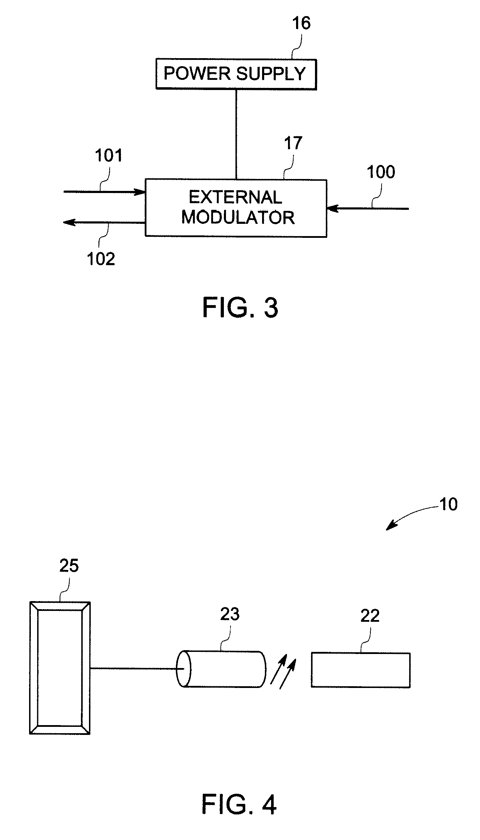

FIG. 3 is a schematic diagram of an external modulator 17 for illustrating the modulation of the monitoring signal from the corresponding sensor. It should be noted that the illustrated arrangement in FIG. 3 is merely illustrative. As depicted in FIG. 3, the power supply 16 powers the external modulator 17. The monitoring signal 100 from the sensor 11 (shown in FIG. 2) and an unmodulated light beam 101 from a source (not shown) are input into the external modulator 17 respectively for modulation, so that the external modulator 17 outputs the optical signal, for example in the form of a modulated light beam 102 carrying the data of the monitoring signal 100, into the optical fiber 18 (shown in FIG. 2). In certain applications, the source for generating the unmodulated light beam 101 may be provided separately or may be integral with other elements, such as the data acquisition system of the monitoring system 10.

For the arrangement in FIG. 2, the transmitting optical fiber 18 is configured to receive and transmit the optical signal to the optical-to-electrical converter 15. The optical-to-electrical converter 15 is configured to convert the optical signal to an electrical signal and to transmit the electrical signal into the data acquisition system 13 for processing. In certain applications, the optical-to-electrical converter 15 may be integral with or be provided separately from the data acquisition system 13. In one non-limiting example, the optical-to-electrical converter 15 may comprise a photodiode.

It should be noted that arrangement depicted in FIG. 2 is merely illustrative. In some applications, more than one sensor 11 may be employed, thus, the monitoring system 10 may comprise more than one electrical-to-optical converters, more than one optical-to-electrical converter, and more than one transmitting optical fiber to cooperate with the respective sensors.

In certain applications, one optical fiber may be employed to transmit a plurality of signals from the respective electrical-to optical converters, and the signals may have the same or different wavelengths. For example, a first electrical-to-optical converter attached to a first sensor generates an optical signal of a wavelength λ1. A second electrical-to-optical converter attached to a second sensor generates an optical signal of a wavelength λ2, which is sufficiently spaced from λ1. Then, the optical signals having the wavelengths λ1 and λ2 may be combined using a wavelength division multiplexing technique and be transmitted over the same one optical fiber. Prior to the transmission of the signals into the data acquisition system, a wavelength selective filter (not shown) may be provided to filter the optical signals having the wavelengths λ1 and λ2 respectively, so that the filtered optical signals are then individually converted to respective electrical signals through one or more optical-to-electrical converters. In addition, the wavelength division multiplexing technique and the wavelength selective filter can be readily implemented by one skilled in the art.

For the illustrated arrangement in FIG. 2, the monitoring system 10 further comprises an amplifier 19 configured to amplify the monitoring signal from the sensor 11 and a coupling capacitor 21 in communication with the amplifier 19 and the electrical-to-optical converter 14. In some examples, the power supply 16 may be further configured to power the amplifier 19. Alternatively, the amplifier 19 may have an independent power supply.

Accordingly, during operation, the sensor 11 monitors partial discharges of the component 20 and outputs an alternating current (AC) monitoring signal to the amplifier 19. Then, the amplifier19 amplifies the AC monitoring signal, and the amplified AC monitoring signal passes through the coupling capacitor 21 to enter into the signal modulator 17. Subsequently, the signal modulator 17 converts the AC monitoring signal to an optical signal to pass through the transmitting optical fiber 18 to enter into the optical-to-electrical converter 15. Finally, the optical-to-electrical converter 15 converts the optical signal to an electrical signal and outputs the electrical signal into the data acquisition system 13 for processing.

In certain embodiments, the power supply 16 may comprise a battery to power the signal modulator 17 and/or the amplifier 19. Alternatively, the power supply 16 may have other configurations. FIG. 4 is a schematic diagram illustrating an example arrangement of the power supply 16 of the monitoring system 10 in accordance with one embodiment of the invention. The illustrated arrangement in FIG. 4 is merely illustrative. For ease of illustration, some elements in the monitoring system 10 are not illustrated.

For the arrangement depicted in FIG. 4, the power supply 16 comprises a photonic power converter 22 configured to convert photons into electrical power. The monitoring system 10 comprises a light source 25 configured to generate radiation, and a power optical fiber 23 in optical communication with the light source to transmit the radiation to the photonic power converter 22. Thus, during operation, the light source generates radiation, and the radiation passes through the power optical fiber 23 to enter into the photonic power converter 22. The photonic power converter 24 converts the radiation to electrical power to energize the signal modulator 17. In some non-limiting examples, the photonic power converter 22 may also be used to power the optical-to-electrical converter 15.

For some arrangements, the light source 25 may be provided separately from the data acquisition system 13. Alternatively, the light source 25 may be integral with the data acquisition system 13. Additionally, the light source 25 may be the same as or different from the source for generating the unmodulated light beam 101. In some examples, the monitoring system 10 may comprise more than one power optical fiber to communicate with multiple photonic power converters.

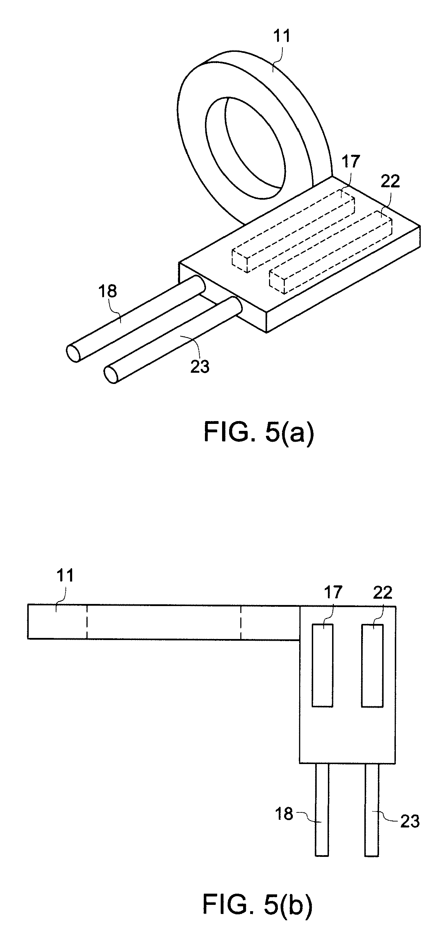

For some arrangements, the sensor 11, the signal modulator 17, and the photonic power converter 22 may be integrated together. As depicted in FIGS. 5(a)-5(b), a perspective view and a top view of an exemplary package of the sensor 11, the signal modulator 17, and the photonic power converter 22 are illustrated. The illustrated arrangement is merely illustrative. For ease of illustration, the amplifier 19 and the coupling capacitor 21 are not shown. However, these elements (the amplifier 19 and the coupling capacitor 21) may also be integrated within the illustrated package. For certain arrangements, the signal modulator 17, the transmitting optical fiber 18, the optical-to-electrical converter 15, and the photonic power converter 22 may be provided separately or may be integrated together.

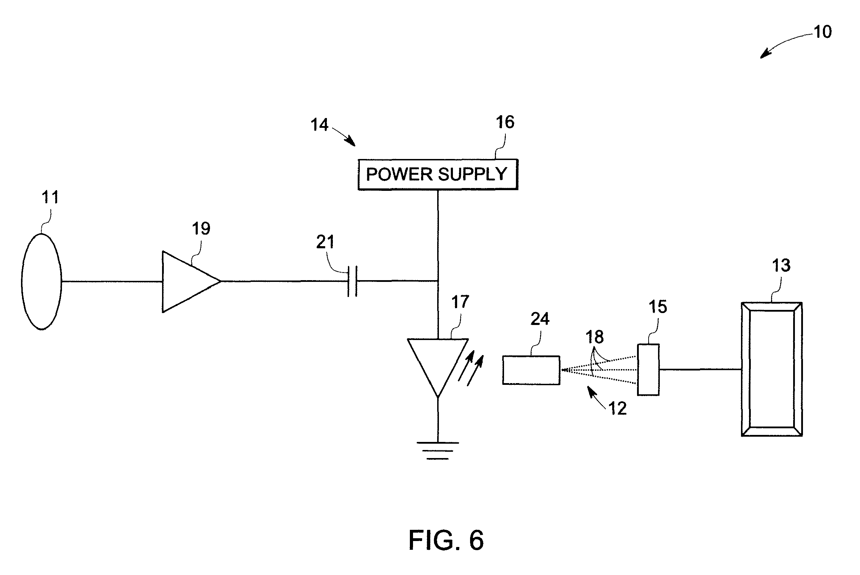

FIG. 6 is a schematic diagram of an exemplary arrangement of the monitoring system 10 in accordance with another embodiment of the invention. The arrangement illustrated in FIG. 6 is merely illustrative and is similar to the arrangement shown in FIG. 2. The two illustrated arrangements shown in FIGS. 2 and 6 differ in that the monitoring system 10 in FIG. 6 comprises an optical splitter 24 in communication with the signal modulator 17, and the optical connector 12 comprises a plurality of optical fibers 18 to communicate with the optical splitter 24.

In embodiments of the invention, the optical splitter 24 is configured to receive and split the optical signal from the signal modulator 17 for transmission through the optical fibers 18, and can be easily implemented by one skilled in the art. Thus, as depicted in FIG. 6, if one optical fiber 18 is damaged, the optical signal may still be conveyed to the data acquisition system 13 via the remaining optical fibers so as to achieve stable transmission of the optical signal.

For completeness, various aspects of the invention are now set out in the following numbered clauses:
1. A system for monitoring one or more components of an aircraft wiring system, the system comprising:
   at least one sensor configured to detect one or more partial discharges produced by a respective one of the components of the aircraft wiring system and to generate at least one monitoring signal;
   at least one electrical-to-optical converter configured to convert the monitoring signal to an optical signal;
   at least one optical connector configured to transmit the optical signal;
   at least one optical-to-electrical converter configured to convert the optical signal to an electrical signal; and
   a data acquisition system configured to process the electrical signal.
2. The system of clause 1, wherein each of the at least one sensor is disposed around a respective one of the at least one aircraft wiring system component.
3. The system of clause 1, wherein each of the at least one optical connector comprises an optical fiber.
4. The system of clause 1, wherein each of the at least one electrical-to-optical converter is disposed at an interface between respective ones of the at least one sensor and the at least one optical connector.
5. The system of clause 1, wherein each of the at least one electrical-to-optical converter comprises a signal modulator configured to convert the monitoring signal to the optical signal.
6. The system of clause 5, wherein each of the at least one electrical-to-optical converter further comprises a power supply for powering the respective signal modulator.
7. The system of clause 6, wherein the power supply comprises a photonic power converter, and wherein the system further comprises at least one power optical fiber configured to supply radiation to the photonic power converter to convert the radiation to power.
8. The system of clause 7, wherein each of the at least one sensor is packaged with a respective one of the photonic power converters.
9. The system of clause 5, wherein the signal modulator comprises a direct signal modulator for converting the monitoring signal to the optical signal by direct modulation.
10. The system of clause 5, wherein the signal modulator is configured to convert the monitoring signal to the optical signal by external modulation.
11. The system of clause 1, wherein the at least one optical connector comprises a plurality of optical fibers, and wherein the system further comprises at least one optical splitter configured to receive and split the optical signal for transmission through the optical fibers.
12. The system of clause 1, wherein the system comprises a plurality of sensors and a plurality of electrical-to-optical converters configured to cooperatively generate a plurality of optical signals with different wavelengths, wherein the system comprises one optical connector for transmitting the optical signals, and wherein the one optical connector comprises one optical fiber.
13. The system of clause 1, wherein each of the at least one sensor comprises a high frequency current transformer, and wherein the monitoring signal comprises an alternating current (AC) monitoring signal.
14. A method for monitoring one or more components of an aircraft wiring system, the method comprising:
   detecting one or more partial discharges produced by a respective one of the aircraft wiring system components to generate one or more monitoring signals;
   converting the one or more electrical monitoring signals to one or more optical monitoring signals;
   transmitting the one or more optical signals towards a data acquisition system;
   converting the one or more optical signals to one or more electrical signals for transmission into the data acquisition system; and
   processing the one or more electrical signals to determine a condition of the respective aircraft wiring system component.
15. The method of clause 14, wherein one or more high frequency current transformers are disposed around respective ones of the aircraft wiring system components to perform the detection of the one or more partial discharges.
16. The method of clause 14, wherein the one or more optical signals are transmitted via one or more optical fibers, and wherein one or more optical-to-electrical converters are employed to perform the second conversion step.
17. The method of clause 14, further comprising optically powering one or more electrical-to-optical converters to perform the first conversion step.
18. The method of clause 17, further comprising transmitting radiation via one or more power optical fibers to respective ones of the one or more photonic power converters to power respective ones of the one or more electrical-to-optical converters.
19. The method of clause 14, wherein the one or more monitoring signals comprise one or more alternating current (AC) monitoring signals, and wherein the first conversion step comprises converting the one or more alternating current signals to the one or more optical signals via direct modulation.
20. The method of clause 14, wherein the one or more monitoring signals comprise one or more alternating current monitoring signals, and wherein the first conversion step comprises converting the one or more alternating current (AC) signals to the one or more optical signals via external modulation.

## Claims

1. A system (10) for monitoring one or more components (20) of an aircraft wiring system, the system (10) comprising:
at least one sensor (11) configured to detect one or more partial discharges produced by a respective one of the components (20) of the aircraft wiring system and to generate at least one monitoring signal (100);
at least one electrical-to-optical converter (14) configured to convert the monitoring signal (100) to an optical signal;
at least one optical connector (12) configured to transmit the optical signal;
at least one optical-to-electrical converter (15) configured to convert the optical signal to an electrical signal; and
a data acquisition system (13) configured to process the electrical signal.

2. The system of claim 1, wherein each of the at least one sensor (11) is disposed around a respective one of the at least one aircraft wiring system component (20), and wherein each of the at least one optical connector (12) comprises an optical fiber (18).

3. The system of claim 1 or 2, wherein each of the at least one electrical-to-optical converter (14) comprises a signal modulator (17) configured to convert the monitoring signal (100) to the optical signal and to be disposed at an interface between respective ones of the at least one sensor (11) and the at least one optical connector (12).

4. The system of claim 3, wherein each of the at least one electrical-to-optical converter (14) further comprises a photonic power converter (22) for powering the respective signal modulator (17), and wherein the system (10) further comprises at least one power optical fiber (23) configured to supply radiation to the photonic power converter (22) to convert the radiation to power.

5. The system of claim 4, wherein each of the at least one sensor (11) is packaged with a respective one of the photonic power converters (22).

6. The system of any of the preceding claims, wherein the at least one optical connector (12) comprises a plurality of optical fibers (18), and wherein the system (10) further comprises at least one optical splitter (24) configured to receive and split the optical signal for transmission through the optical fibers (18).

7. The system of any of the preceding claims, wherein the system (10) comprises a plurality of sensors (11) and a plurality of electrical-to-optical converters (14) configured to cooperatively generate a plurality of optical signals with different wavelengths, wherein the system comprises one optical connector (12) for transmitting the optical signals, and wherein the one optical connector (12) comprises one optical fiber (18).

8. A method for monitoring one or more components (20) of an aircraft wiring system, the method comprising:
detecting one or more partial discharges produced by a respective one of the aircraft wiring system components (20) to generate one or more monitoring signals (100);
converting the one or more electrical monitoring signals (100) to one or more optical monitoring signals;
transmitting the one or more optical signals towards a data acquisition system (13);
converting the one or more optical signals to one or more electrical signals for transmission into the data acquisition system (13); and
processing the one or more electrical signals to determine a condition of the respective aircraft wiring system component (20).

9. The method of claim 8, wherein one or more high frequency current transformers (11) are disposed around respective ones of the aircraft wiring system components (20) to perform the detection of the one or more partial discharges, wherein the one or more optical signals are transmitted via one or more optical fibers (18), and wherein one or more optical-to-electrical converters (15) are employed to perform the second conversion step.

10. The method of claim 8 or 9, further comprising optically powering one or more electrical-to-optical converters (14) to perform the first conversion step, and transmitting radiation via one or more power optical fibers (23) to respective ones of the one or more photonic power converters (22) to power respective ones of the one or more electrical-to-optical converters (14).

11. The method of any of claims 8 to 10, wherein the one or more monitoring signals comprise one or more alternating current (AC) monitoring signals, and wherein the first conversion step comprises converting the one or more alternating current signals to the one or more optical signals via direct modulation.

12. The method of any of claims 8 to 11, wherein the one or more monitoring signals comprise one or more alternating current monitoring signals, and wherein the first conversion step comprises converting the one or more alternating current (AC) signals to the one or more optical signals via external modulation.
